# FASCICULE DE BREVET EUROPEEN

(11) **EP 2 633 525 B1**
(45) Date de publication et mention de la délivrance du brevet: **19.08.2015**
(21) Numéro de dépôt: 11810646.7
(22) Date de dépôt: 11.10.2011
(51) Int. Cl.: H01F 10/32, H01L 43/08, G11C 11/16

(54) **ELEMENT MAGNETIQUE INSCRIPTIBLE.**
BESCHREIBBARES MAGNETISCHES ELEMENT
WRITABLE MAGNETIC ELEMENT

(30) Priorité: 26.10.2010 FR 1004198
(43) Date de publication de la demande: 04.09.2013
(73) Titulaire: Centre National de la Recherche Scientifique, 75016 Paris (FR); Commissariat à l'Énergie Atomique et aux Énergies Alternatives, 75015 Paris (FR); Université Joseph Fourier, 38041 Grenoble Cedex 9 (FR); Institut Català De Nanotecnologia (ICN), 08193 Bellaterra (ES); Fundació Institució Catalana de Recerca I Estudis Avançats (ICREA), 08010 Barcelona (ES)
(72) Inventeur: GAUDIN, Gilles Louis, F-38700 Le Sappey (FR); MIRON, Ioan Mihai, E-08301 Mataro (ES); GAMBARDELLA, Pietro, E-08197 Sant Cugat DelValles (ES); SCHUHL, Alain, F-38000 Grenoble (FR)
(74) Mandataire: Corret, Hélène
(86) Numéro de dépôt international: PCT/IB2011/054480
(87) Numéro de publication internationale: WO 2012/056348

(56) Documents cités:
- EP-A1- 1 555 694
- EP-A1- 1 610 386
- EP-A2- 1 298 669
- US-A1- 2009 129 143
- US-B1- 6 317 359
- US-B1- 7 009 877

## Description

La présente invention a pour objet un élément magnétique inscriptible du type à retournement induit par un courant.

Le retournement de l'aimantation d'une couche ou d'un petit élément magnétique se fait communément au moyen d'un champ magnétique appliqué. La direction de celui-ci est par exemple changée suivant que l'on veuille retourner l'aimantation dans un sens ou dans un autre. C'est ce principe qui est à la base de l'écriture dans des pistes magnétiques ou des disques durs d'ordinateur : l'élément à retourner est mécaniquement placé au voisinage du générateur de champ magnétique de façon à localiser spatialement ce champ. C'est en effet la structure même du champ magnétique, par définition non localisé dans l'espace, qui soulève de nombreuses difficultés pour son intégration dans des dispositifs. Ainsi, lorsque qu'aucune actuation mécanique n'est possible ou désirée, par exemple dans le cas des mémoires magnétiques solides de type "MRAM" (magnetic random access memory) ou des dispositifs logiques, il faut localiser suffisamment le champ magnétique pour que celui-ci n'agisse que sur la cellule cible sans impacter ses voisines. Ce problème devient de plus en plus important lorsque les différentes cellules mémoire ou logiques sont disposées très proches les unes des autres afin d'augmenter les densités.

La possibilité de manipuler l'aimantation au moyen d'un courant polarisé en spin qui a été démontrée tout d'abord théoriquement en 1996 a apporté une première solution à ce problème. Ce principe physique, appelé couple de transfert de spin (STT pour spin transfer torque en anglais) nécessite la présence, pour manipuler l'aimantation au niveau du point mémoire, d'au moins deux couches magnétiques séparées par un métal non magnétique (pour une structure de type vanne de spin) ou par un isolant (pour une structure de type jonction tunnel magnétique), les deux couches ayant leur aimantations non colinéaires. L'explication physique détaillée diffère suivant que l'on est en présence d'une structure vanne de spin ou jonction tunnel magnétique mais globalement le courant se polarise en spin à la traversée de la première couche magnétique, pour ensuite exercer un couple sur l'aimantation de la seconde couche au moyen de la composante non colinéaire de la polarisation du courant. Lorsque les densités de courant sont suffisantes, l'aimantation de la seconde couche magnétique peut être retournée à la fois pour les vannes de spin et les jonctions tunnel magnétiques.

Comme décrit par exemple dans le Brevet US 7 009 877 publié le 7 Mars 2006 et dans la Demande US 2009/129143 publiée le 21 Mai 2009, le courant électrique traverse nécessairement la jonction perpendiculairement au plan des couches.

Cette possibilité de manipuler localement l'aimantation d'un élément magnétique de taille sub-micronique au moyen d'un courant électrique a tout de suite généré des possibilités d'application. De nos jours, c'est l'intégration de ce principe dans les nouvelles architectures de cellules mémoire MRAM et des composants logiques qui est recherchée par les acteurs industriels.

Cette intégration se heurte pour l'instant à différentes difficultés qui semblent entrelacées.

Le retournement par STT nécessite la présence au niveau du point mémoire d'au moins deux couches magnétiques séparées par un espaceur non magnétique. L'écriture se fait comme décrit ci-dessus en injectant un courant de forte densité à travers tout l'empilement perpendiculairement au plan des couches magnétiques, tandis que la lecture se fait au moyen de la magnétorésistance de l'empilement : magnétorésistance géante (GMR) pour les vannes de spin, et magnétorésistance tunnel (TMR) pour les jonctions tunnel magnétiques. De nos jours, toutes les applications ou presque sont basées sur l'utilisation de jonctions tunnel magnétiques. Ainsi, si le signal GMR n'est que de quelques pourcents, le signal TMR de jonctions à base de MgO est communément supérieur à 100%. Les jonctions tunnel ont néanmoins le désavantage de présenter des valeurs du produit résistance * surface (RA) importantes. Ainsi, pour une densité de courant typique de 10⁷ A/cm² nécessaire au retournement par STT, la tension aux bords de la jonction est de 10V pour un RA de 100Ω.µm², 1V pour un RA de 10 Ω.µm² et 0.1V pour un RA de 1 Ω.µm². Hormis pour la valeur la plus faible, la puissance dissipée dans la jonction est alors importante ce qui est préjudiciable à la fois en terme de consommation énergétique et d'endommagement de la dite jonction.

De plus, les valeurs importantes de TMR utiles à la lecture sont souvent obtenues pour des empilements présentant des valeurs de RA importantes.

Cela explique les recherches actuelles pour obtenir des jonctions tunnel présentant de fortes valeurs de TMR et de faibles valeurs de RA. De plus, même pour des valeurs relativement faibles de tension aux bords de la jonction, des phénomènes de vieillissement accéléré de la jonction dus aux cycles en tension ont été observés en fonctionnement. De nombreuses études sont consacrées actuellement à ce point à la fois pour optimiser les matériaux dans les géométries existantes mais aussi pour définir de nouvelles géométries permettant de découpler autant que possible les problématiques d'écriture et de lecture par exemple en utilisant des géométries à trois terminaux.

En résumé, une difficulté réside dans l'impossibilité d'optimiser indépendamment la lecture et l'écriture car, dans les dispositifs à transfert de spin (STT) connus, les deux phénomènes sont intrinsèquement liés.

Une autre difficulté inhérente encore à ce lien provient de la complexité toujours plus grande des empilements. Ainsi, si l'on veut que l'effet de transfert de spin (STT) ne se fasse ressentir que dans la couche à retourner pour stocker l'aimantation, il faut par exemple stabiliser les autres couches au moyen par exemple d'un couplage d'échange avec un matériau antiferromagnétique ; si l'on veut augmenter l'amplitude du transfert STT, il faut optimiser les couches polarisantes ; si l'on veut diminuer les champs magnétiques rayonnés sur les couches sensibles, il faut utiliser par exemple des bicouche antiferromagnétiques artificielles ; etc...

Il en résulte que les empilements magnétiques typiques de cellules MRAM ou composants logiques peuvent comporter plus de 10 ou 15 couches différentes de matériaux divers. Ceci pose ensuite des difficultés dans les étapes de structuration et notamment dans l'étape de gravure qui est un des points de blocage les plus importants pour l'intégration de ces empilements magnétiques.

Une autre voie de recherche est de manipuler l'aimantation au moyen d'un champ électrique local. Ceci peut être partiellement accompli en modifiant l'anisotropie d'un matériau au moyen d'un champ électrique extérieur, le retournement de l'aimantation s'effectuant au moyen d'un champ magnétique appliqué. Une telle technique est décrite dans l'article de T. MARUYAMA et collaborateurs intitulé « Large voltage-induced magnetic anisotropy charge in a few atomic layers of iron » (Nature Nanotechnology, vol. 4, March 2009 - Macmillan Publishers Ltd.).

EP1.298.669 décrit un élément magnétique inscriptible avec un empilement d'une couche centrale et une première et une deuxième couche externe. La première couche externe est isolant et la deuxième couche externe est conductrice. Un courant d'écriture passe au plan de la couche centrale et de la deuxième couche externe et créé un champ magnétique pour orienter la direction d'aimantation dans la couche centrale.

Cette technique ne permet actuellement que de réduire l'anisotropie du matériau. Les processus d'écriture et de lecture sont alors les mêmes que ceux décrits ci-dessus, ainsi que leurs inconvénients.

La présente invention a pour objet un élément magnétique inscriptible qui, pour inverser l'aimantation, ne nécessite la présence que d'une couche magnétique (ayant une aimantation parallèle à son plan) et qui fonctionne sans que l'empilement ne soit traversé par un courant d'écriture perpendiculairement au plan des couches.

L'invention concerne ainsi un élément magnétique inscriptible comportant un empilement de couches présentant une couche magnétique d'écriture, caractérisé en ce que l'empilement comporte une couche centrale en au moins un matériau magnétique présentant une aimantation ayant une direction d'aimantation parallèle au plan de la couche centrale, celle-ci étant prise en sandwich entre une première et une deuxième couches externes en matériaux non magnétiques, la première couche externe comportant un premier matériau non magnétique et la deuxième couche externe comportant un deuxième matériau non magnétique différent du premier matériau non magnétique, au moins le deuxième matériau non magnétique étant électriquement conducteur, en ce qu'il comporte un dispositif pour faire passer un courant d'écriture à travers la deuxième couche externe et la couche centrale dans une direction de courant parallèle au plan de la couche centrale et faisant un angle a de 90° ± 60°, notamment de 90° ± 30° et plus particulièrement de 90° ± 15° avec ladite direction d'aimantation parallèle au plan de la couche centrale, pour générer dans la couche centrale un champ magnétique effectif (ou champ de spin-orbite), ce courant d'écriture étant appliqué, soit dans un premier sens, soit dans un deuxième sens opposé au premier sens pour orienter la direction d'aimantation dans un premier sens d'aimantation ou dans un deuxième sens d'aimantation opposé au premier sens d'aimantation.

La présente invention présente l'important avantage supplémentaire de permettre des opérations d'écriture sans application d'un champ magnétique externe.

Le champ magnétique efficace (ou champ magnétique de spin-orbite) est dû au champ Rashba et à l'interaction d'échange s-d, agissant sur l'aimantation locale, ainsi qu'il sera expliqué plus loin dans la description.

L'idée de base de l'invention est d'utiliser le champ magnétique de spin-orbite pour manipuler l'aimantation de la couche magnétique. Ceci est réalisé selon l'invention, sans avoir besoin d'un champ magnétique appliqué, en orientant l'aimantation de la couche magnétique de préférence colinéairement à la direction du champ magnétique de spin-orbite qui est fixée par la géométrie de l'empilement, des interfaces, et la direction du courant. La direction du courant d'écriture est de préférence perpendiculaire à ladite direction de l'aimantation.

Le courant électrique d'écriture circule parallèlement à la couche magnétique et ne traverse pas l'empilement dans une direction perpendiculaire au plan des couches, et la mémoire peut être écrite ou effacée en agissant, sur le sens dudit courant et plus particulièrement en appliquant une impulsion de courant, sans qu'il soit besoin d'appliquer un champ magnétique externe.

La couche centrale a avantageusement une épaisseur comprise entre 0,1 nm et 5 nm et de préférence inférieure ou égale à 3 nm.

La couche centrale comporte avantageusement un métal ou un alliage de métaux présentant dans l'empilement une anisotropie magnétique planaire, notamment Co, Fe, Ni, CoₓFe_{y}, NiₓFe_{y}, CoₓNi_{y}, etc..., l'aimantation de cette couche centrale étant contenue dans le plan de la couche centrale.

Au moins une couche externe conductrice est avantageusement en un métal non magnétique de préférence Pt, W, Ir, Ru, Pd, Cu, Au, Ag, Bi, ou en un alliage de ces métaux, ou bien en un semiconducteur fortement dopé (dopage++) tel que Si, Ge, ou GaAs. L'épaisseur d'une telle couche conductrice est par exemple comprise entre 0,5 nm et 100 nm, plus particulièrement entre 1 nm et 10 nm et de préférence inférieure ou égale à 5 nm. Les deux couches externes peuvent être électriquement conductrices, mais elles sont alors choisies en deux dits métaux ou alliages de métaux non magnétiques différents. L'épaisseur d'une couche externe conductrice n'a pas de lien avec l'épaisseur de la couche centrale.

La première couche externe, lorsqu'elle est électriquement non conductrice, est avantageusement en un oxyde diélectrique de préférence SiOx, AlOx, MgOx, TiOx, TaOx ZnO, HfO ou bien un nitrure diélectrique tel que SiNx, BNx, ou bien encore en un semiconducteur (par exemple Si, Ge, AsGa) intrinsèque ou très faiblement dopé de façon que la résistivité soit supérieure à 0,1 Ω.cm (soit un niveau de dopage typiquement inférieur à 10¹⁶/cm³ pour Si ou Ge) et de préférence supérieure à 1 Ω.cm. L'épaisseur de cette couche externe est par exemple comprise entre 0,5 nm et 200 nm, notamment entre 0,5 nm et 100 nm. Elle est plus particulièrement comprise entre 0,5 nm et 5 nm, préférentiellement inférieure à 3 nm, notamment si la lecture de l'élément mémoire se fait au moyen d'un signal de magnétorésistance tunnel. Dans tous les cas, l'épaisseur de cette couche n'a pas de lien avec l'épaisseur de la couche centrale.

La densité du courant d'écriture est comprise par exemple entre 10⁴ A/cm² et 10⁹ A/cm², et plus particulièrement entre 10⁵ A/cm² et 10⁸ A/cm².

La première couche externe peut être recouverte d'une couche de lecture en matériau magnétique et d'une électrode de lecture.

Un dispositif peut être couplé à l'électrode de lecture pour faire passer un courant de lecture à travers l'empilement ainsi formé et pour mesurer la résistance aux bornes de l'empilement.

Dans le cas où la première couche externe est en métal non magnétique, elle forme avec la couche centrale, la couche de lecture et l'électrode de lecture une vanne de spin. L'épaisseur de la première couche externe est alors comprise entre 0,5 nm et 10 nm et de préférence inférieure à 5 nm.

Dans le cas où la première couche externe est diélectrique, elle forme avec la couche centrale, la couche de lecture et l'électrode de lecture une jonction tunnel magnétique. Dans ce cas, l'épaisseur de la première couche externe est comprise entre 0,5 nm et 5 nm et de préférence inférieure à 3 nm.

La première couche externe et la couche centrale forment avantageusement un plot. La deuxième couche externe peut comporter une région en surépaisseur qui fait partie du plot. Une piste est avantageusement formée soit par la deuxième couche externe, soit par une piste électriquement conductrice qui borde la deuxième couche externe.

L'invention concerne également un dispositif magnétique inscriptible, comportant une pluralité de plots tels que définis ci-dessus et en ce que la deuxième couche externe comporte une dite piste qui leur est commune.

L'invention concerne enfin un dispositif magnétique inscriptible, caractérisé en ce que la première couche externe, la couche centrale et une région en surépaisseur constituant la deuxième couche externe forment un plot, et en ce qu'il comporte une pluralité desdits plots, ainsi qu'une piste électriquement conductrice bordant la deuxième couche externe desdits plots pour injecter ledit courant à travers la deuxième couche externe et la couche centrale de chacun desdits plots, la deuxième couche externe étant en un matériau électriquement conducteur différent de celui de la piste électriquement conductrice.

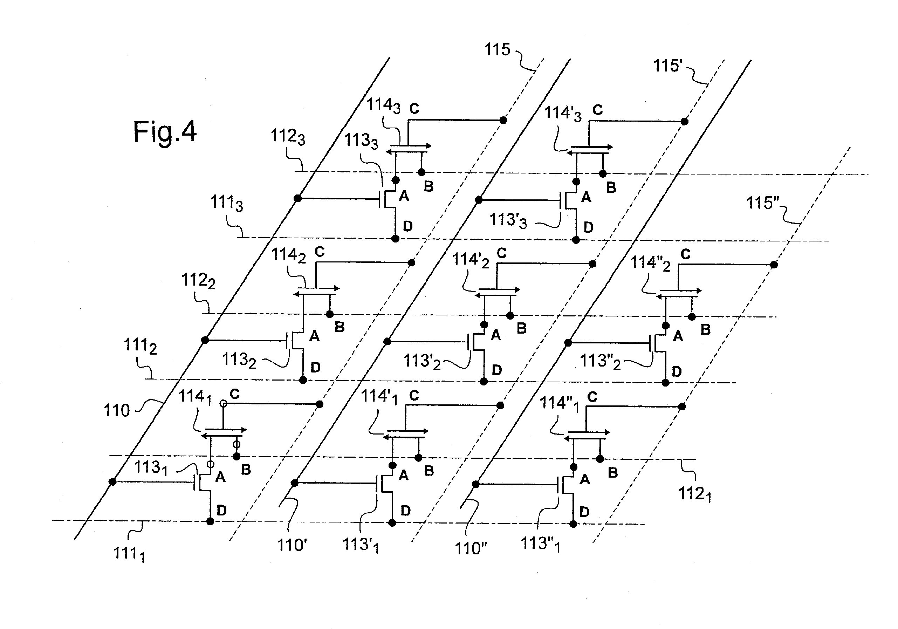

La figure 4 est un exemple d'intégration d'un élément magnétique selon l'invention constituant une cellule mémoire, pour former un réseau mono ou bi-dimensionel.

L'invention sera mieux comprise à la lecture de la description ci-après, en liaison avec les dessins dans lesquels les figures 1a à 1g illustrent des mises en oeuvre de l'invention, dont les figures 2a et 2b représentent un mode de réalisation intégré dans une cellule mémoire magnétique de type "MRAM", et dont les figures 3a et 3b illustrent des modes de réalisation dans chacun desquels plusieurs éléments de mémoire sont représentés pour illustrer l'architecture de la mémoire.

L'empilement mis en oeuvre dans le cadre de la présente invention, à savoir une couche magnétique centrale, en sandwich entre deux couches externes non magnétiques, dont au moins une est conductrice, les deux couches externes étant en des matériaux différents, a pour effet de créer une asymétrie d'inversion qui génère un champ électrique non compensé dans la couche centrale magnétique. Les électrons se propageant dans ce champ électrique sont soumis dans leur référentiel propre à un champ magnétique appelé champ Rashba *̅H̅_̅{̅R̅}̅*̅ dont la direction est perpendiculaire à la fois au courant circulant dans la couche conductrice et au champ électrique. Ce champ magnétique s'applique donc sur les électrons de conduction.

Les inventeurs ont montré qu'un champ magnétique effectif (dénommé également champ magnétique de spin-orbite) résultant de ce champ Rashba et de l'interaction d'échange couplant le spin des électrons itinérants et localisés s'applique sur l'aimantation locale.

L'article de Ioan Mihai MIRON et Collaborateurs, intitulé « Current-driven spin torque induced by the Rashba effect in a ferromagnetic metal layer », et publié dans Nature Materials / Advance Online Publications, vol. 9, pages 230-234 en Mars 2010 (Macmillan Publishers Ltd) montre un empilement comportant une couche de Pt (3 nm) une couche de Co (0,6 nm) ayant une aimantation perpendiculaire à son plan et donc parallèle à l'axe z, et une couche de AlOx (2 nm) parcourue par un courant circulant parallèlement à l'axe x. Cet empilement présente un champ magnétique effectif H_{eff} (ou champ magnétique de spin-orbite) selon le troisième axe du trièdre, l'axe y. Cette configuration est de fait inappropriée à la réalisation d'une mémoire, car ce champ magnétique est perpendiculaire à l'aimantation de la couche magnétique.

De manière surprenante, les inventeurs ont montré que cet obstacle théorique pouvait être franchi dans une configuration différente de celle décrite dans l'article précité en permettant une orientation de l'aimantation de la couche magnétique de préférence colinéaire à la direction du champ magnétique effectif généré par le courant. Lorsqu'un courant d'écriture est injecté dans la couche centrale, mais perpendiculairement à la direction de l'aimantation qui est dans le cas présent située dans le plan de la couche centrale magnétique, il est généré un champ de spin-orbite colinéaire à la direction de l'aimantation et un changement du sens de l'aimantation peut être obtenu selon l'invention en fonction du sens de circulation du courant d'écriture injecté, sans application d'un champ magnétique externe. Ce changement du sens de l'aimantation continue à être obtenu selon l'invention lorsque la direction du courant dans le plan de la couche centrale n'est pas perpendiculaire à la direction d'aimantation, mais forme avec celle-ci un angle α de 90° ± 30°, notamment de 90° ± 30°, et plus particulièrement de 90° ± 15°. En effet, le champ magnétique effectif garde une composante colinéaire à la direction d'aimantation de la couche centrale.

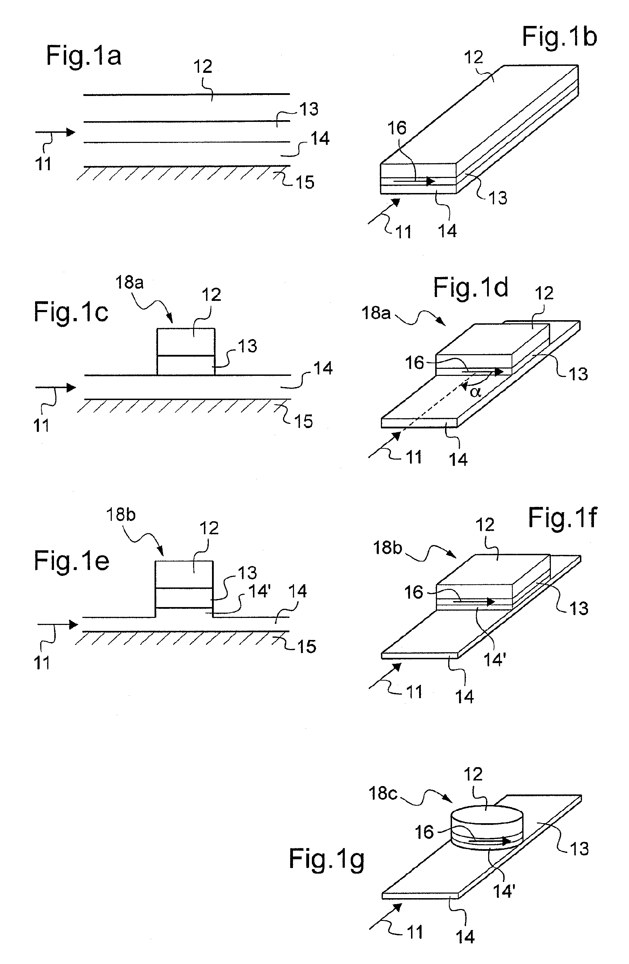

Aux figures 1a à 1g, la référence 15 désigne un substrat qui est un isolant électrique, afin de ne pas court-circuiter la structure. Il peut être notamment constitué par un oxyde diélectrique (SiO₂, AlOx, MgOx, TiOx, TaOx, ZnO, HfO), ou par un nitrure par exemple SiNx. Il peut être seul ou déposé sur un autre substrat par exemple en silicium.

La référence 13 désigne la couche magnétique plane dont l'aimantation est parallèle à son plan. La référence 16 désigne l'orientation de l'aimantation qui est contenue dans le plan de la couche magnétique 13.

Les références 14 et 12 désignent les couches externes non magnétiques.

La référence 11 désigne la direction du courant d'écriture qui est parallèle au plan de la couche 13, mais qui, dans cet exemple, est perpendiculaire à l'aimantation. Comme indiqué ci-dessus, la direction du courant peut former un angle α (figure 1d) de 90° ± 60° (30° < α < 150°), de 90° ± 30° (60° < α < 120°) et plus particulièrement de 90° ± 15° (75° < α < 105°) avec la direction 16 de l'aimantation.

Les figures 1a et 1b montrent un empilement non structuré dans lequel les couches 12, 13 et 14 de l'empilement forment une piste.

La direction 16 de l'aimantation est dans cet exemple perpendiculaire à la direction longitudinale de la piste qui constitue la couche conductrice 14 dans laquelle le courant est injecté.

Les figures 1c à 1g montrent un empilement structuré dans lequel la couche 14 (dénommée deuxième couche externe) est conductrice et les couches magnétique 13 et non magnétique 12 (dénommée première couche externe) sont seules structurées pour former des plots 18a (Figures 1c et 1d) ou bien dans lequel les trois couches 12, 13, 14 sont structurées pour constituer un plot 18b ou 18c intégrant (Figures 1e à 1g) une surépaisseur optionnelle 14' de la couche conductrice 14, de sorte que le plot (18b ou 18c) contienne une partie de l'épaisseur du matériau non magnétique de la couche 14.

L'épaisseur à prendre en compte pour la deuxième couche externe est dans ce cas celle de la couche 14 proprement dite et de la surépaisseur 14'.

On notera que la région en surépaisseur 14' n'est pas nécessairement dans le même matériau électriquement conducteur que la couche 14 auquel cas c'est cette surépaisseur seule 14' qui fait fonction de deuxième couche externe non magnétique et c'est son matériau qui est fonctionnel dans l'empilement pour obtenir une asymétrie d'inversion. Le matériau métallique de la couche 14 peut alors être quelconque.

La formation de plots 18a, 18b ou 18c permet de ne retourner l'aimantation que dans les plots, sinon l'aimantation est retournée sur toute la longueur de la piste (figures 1a et 1b).

La direction 16 d'aimantation dans les plots 18a à 18c est de préférence perpendiculaire à l'axe longitudinal de la piste conductrice 14 qui est parallèle à la direction 11 de circulation du courant. Pour obtenir une telle direction d'aimantation qui est colinéaire à la direction du champ de spin-orbite, on peut réaliser par exemple un plot elliptique par exemple 18c, dont le grand axe est perpendiculaire à l'axe longitudinal de la piste conductrice 14 (la surépaisseur 14' est optionnelle) pour obtenir une anisotropie de forme selon la direction désirée.

La couche magnétique 13 présente une direction d'aimantation située dans son plan et a une épaisseur assez fine pour que le champ électrique dû aux interfaces ne soit pas négligeable. Son épaisseur ne dépasse typiquement pas 3 nm et elle est au maximum de 5 nm. Tous les matériaux magnétiques présentant une aimantation planaire (Co, Fe, Ni, CoₓFe_{y}, NiₓFe_{y}, CoₓNi_{y}, etc) peuvent être utilisés. On peut aussi prendre des matériaux magnétiques non métalliques comme par exemple des semi-conducteurs magnétiques tels que GaMnAs (GaAs dopé au Mn), le InMnAs, le Mnₓ Ge(1-x), le ZnO dopé ou bien encore le TiOₓ.

Les deux couches non-magnétiques 12 et 14 doivent être différentes afin de créer une asymétrie d'inversion dans la structure globale. On choisit deux matériaux différents pour chacune de ces couches, par exemple un diélectrique pour l'une des deux et un métal pour l'autre, mais on peut choisir aussi un métal pour chacune d'entre elles. Le cas où les deux couches 12 et 14 sont électriquement non conductrices n'est possible que si on ne structure pas un plot, mais une piste. On fait alors circuler le courant dans la couche centrale 13 qui constitue une piste.

Ainsi, chacune des deux couches non magnétiques 12 et 14 peut être constituée des matériaux suivants, avec la condition que ces couches soient différentes pour que l'empilement 12, 13, 14 présente une asymétrie d'inversion, un oxyde diélectrique (SiOₓ, AlOₓ, MgOₓ, TiOₓ, TaOₓ, ZnO, HfOₓ...), un nitrure diélectrique, (SiNₓ, BNₓ,...), un métal non magnétique (Pt, Pd, Cu, Au, Bi, Ir, Ru, W,...) un alliage non magnétique de ces métaux, un composé semi-conducteur organique ou non (par exemple GaAs, Si, Ge dopé ou non) un graphène lié si besoin à un "buffer" de croissance par exemple un métal (comme l'Ir, Ru, Ni) ou un composé semi-conducteur comme le SiC.

Une couche électriquement non conductrice est par exemple en un matériau semiconducteur (par exemple Si, Ge, GaAs) intrinsèque ou faiblement dopé de façon que leur résistivité soit supérieure à 0,1 Ω.cm (ce qui correspond à un niveau de dopage typiquement inférieur à 10¹⁶/cm³ pour Si ou Ge) et de préférence supérieure à 1 Ω.cm.

Pour une couche électriquement conductrice en matériau semiconducteur, il convient de prévoir un semiconducteur fortement dopé (dopage⁺⁺), avec par exemple dans le cas de Si ou Ge, une densité de porteurs de 10¹⁸/cm³ ou plus.

Dans le cas ou les couches non magnétiques sont l'une ou l'autre conductrices, les deux couches externes ne doivent pas avoir la même composition.

L'épaisseur des couches 12 et 14 peut être choisie dans une large gamme de valeurs, typiquement de 0,5 à 200 nm d'épaisseur et plus particulièrement entre 0,5 nm et 100 nm. Néanmoins, dans le cas de couches 12 et/ou 14 métalliques, on privilégie des couches fines, typiquement inférieures à 5 nm et généralement inférieures à 10 nm, de façon à ne pas trop diminuer le courant efficace passant dans la couche magnétique à cause de ces canaux conducteurs en parallèle. Dans le cas de couches isolantes, celles-ci peuvent être prises épaisses, jusqu'à environ 200 nm d'épaisseur, sauf si l'empilement est intégré à une mémoire lue par jonction tunnel magnétique (TMR), auquel cas cette épaisseur devra être typiquement inférieure à 3 nm.

Ces différentes couches peuvent être déposées par toute technique connue telle que : évaporation, pulvérisation, dépôt par voie électrochimique, croissance chimique,....

La couche 14 peut être omise dans certaines géométries. La couche magnétique 13 est alors déposée directement sur le substrat isolant 15 (qui fait fonction de couche non magnétique) et la couche non magnétique 12 est en un matériau différent de celui constituant le substrat 15 choisie de façon à ce que l'empilement présente l'asymétrie d'inversion. Il faut néanmoins remarquer que dans le cas où des plots sont structurés, la couche 14 doit être présente et constituée d'un matériau conducteur électrique de façon à pouvoir injecter du courant dans les plots structurés (ici 18a et 18b).

L'élément à retourner, que ce soit la piste représentée (Figure 1a ou 1b) ou un plot reporté ou structuré sur la piste (Figures 1c à 1g), est connecté par des électrodes conductrices connues en soi, de façon à injecter un courant d'écriture dans la direction 11. Les densités de courant peuvent être comprises entre 10⁴ A/cm² et 10⁹ A/cm² et plus particulièrement entre 10⁵ A/cm² et 10⁸ A/cm². Ce courant d'écriture ne traverse pas perpendiculairement aux couches l'empilement (12, 13, 14), lequel n'est susceptible d'être traversé perpendiculairement aux couches que par le courant de lecture dont l'intensité est beaucoup plus faible.

Ainsi, le courant d'écriture qui circule dans une direction de courant parallèle au plan de la couche centrale circule seulement à travers la deuxième couche externe et la couche centrale, et éventuellement à travers la première couche externe, mais seulement dans le cas où celle-ci est conductrice.

L'injection de courant dans la piste 14 dans le sens de la flèche 11 (ou en sens inverse) permet de commuter l'aimantation de la couche 13 au moyen du champ magnétique effectif produit sur l'aimantation par l'interaction spin-orbite et le couplage d'échange. L'aimantation est orientée dans le plan de la couche centrale magnétique 13 et dans cet exemple perpendiculairement à la direction d'injection de courant. Le champ magnétique effectif est parallèle à l'aimantation, ce qui permet une inscription des points mémoire par retournement de l'aimantation en fonction du sens du courant injecté.

Si la direction d'aimantation de la couche centrale n'est pas perpendiculaire à la direction d'injection de courant, l'inscription reste possible tant que ces directions ne sont pas colinéaires, car le champ magnétique effectif garde une composante colinéaire à la direction d'aimantation de la couche. On choisira un angle α entre la direction d'injection de courant et la direction d'aimantation de 90° ± 60°, notamment 90° ± 30°et plus particulièrement de 90° ± 15°.

Lorsque α est différent de 90°, le champ magnétique de spin-orbite aligne sur lui l'aimantation lors de l'application du courant d'écriture. L'aimantation reprend sa direction, mais avec le sens opposé lors de l'arrêt de l'impulsion du courant d'écriture. En changeant le sens du courant d'écriture, la direction d'aimantation est conservée, mais le sens en est inversé.

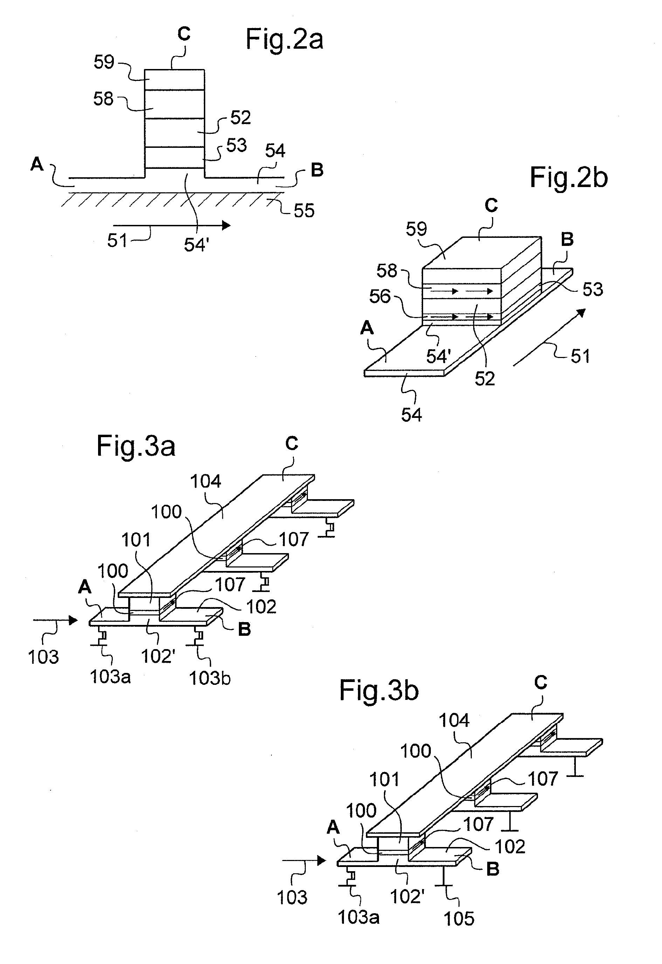

Les figures 2a et 2b sont un exemple d'empilement utilisable dans une cellule de mémoire MRAM.

La référence 53 désigne la couche centrale magnétique prise en sandwich entre deux matériaux non magnétiques différents 52 et 54 avec une surépaisseur 54' (optionnelle), pour réaliser l'empilement tel que décrit ci-dessus, sur un substrat 55 électriquement isolant.

La référence 51 désigne la direction du courant dans la piste 54, et 56 la direction de l'aimantation dans la couche 53, qui dans cet exemple est prise perpendiculairement à la direction d'injection du courant.

Au-dessus de l'empilement sont disposées pour la lecture une couche 58 d'un matériau magnétique et une électrode supérieure 59 pouvant contenir une ou plusieurs couches conductrices (magnétiques ou non magnétiques).

La fonction de la couche 58 est de permettre que la structure 53, 52, 58 présente des valeurs de résistance électrique différentes suivant le sens de l'aimantation 56 de la couche 53 (signal de magnétorésistance). Elle n'intervient que pour la lecture et n'a aucun effet sur la manipulation de l'aimantation de la couche 53.

En d'autres termes, l'écriture et la lecture sont définies de manière indépendante et peuvent être optimisées séparément.

L'électrode 59 peut comporter une couche ou bien, de manière connue en soi, un empilement de différentes couches fonctionnelles. Il peut contenir par exemple :
un empilement définissant un antiferromagnétique synthétique de façon à limiter les champs rayonnés sur la couche que l'on cherche à manipuler 53 ; par exemple un empilement comprenant une couche ferromagnétique séparée de la couche ferromagnétique 58 par une très fine couche d'un matériau métallique non magnétique, typiquement 0,3 nm de Ru, les valeurs des aimantations des deux couches ferromagnétiques étant le plus proche possible, de telle sorte que le couplage antiferromagnétique entre elles qui est dû à la présence de la couche de ruthénium résulte en un champ total rayonné par ces trois couches sur la couche 53 soit nul, soit quasi nul ;
ou bien un matériau magnétique antiferromagnétique couplé par échange à la couche 58 de façon à stabiliser cette couche 58 dite de référence ;
ou bien des matériaux conducteurs non magnétiques pour réaliser des contacts électriques ;
ou encore une combinaison de ces différentes possibilités par exemple un matériau antiferromagnétique adjacent à un matériau ferromagnétique de manière à stabiliser l'aimantation de celui-ci par le couplage entre ces deux matériaux, ce matériau ferromagnétique étant séparé de la couche 58 par une fine couche métallique, typiquement 0,3nm de Ru de façon que le couplage magnétique entre ces deux couches ferromagnétiques soit antiferromagnétique. Enfin, le premier matériau magnétique est recouvert d'une ou plusieurs couches conductrices non magnétiques, par exemple 5nm de Ta recouvert de 7nm de Ru. On trouvera des exemples de telles combinaisons par exemple dans des empilements magnétiques utilisés pour le retournement par STT décrit dans B. DIENY et al., Int. J. Nanotechnology, vol. 7, 591 (2010).

Deux configurations principales peuvent être distinguées suivant la nature de la couche non magnétique 52 : si elle est en métal non magnétique, la structure 53, 52, 58 est de type vanne de spin, tandis que si la couche 52 est diélectrique, la structure 53, 52, 58 est du type jonction tunnel magnétique. Le signal de magnétorésistance étant beaucoup plus important pour ces structures, ce seront celles-ci qui seront privilégiées. De même, pour optimiser le signal de magnétorésistance, on privilégie dans l'un et l'autre cas, la configuration dans laquelle l'aimantation de la couche 58 est colinéaire, soit parallèle, soit antiparallèle, à celle de la couche 53. Dans le cas où la couche 52 est électriquement conductrice, par exemple en métal non magnétique, son épaisseur est avantageusement inférieure à 10 nm et de préférence inférieure à 5 nm, tandis que dans le cas où la couche 52 est diélectrique, son épaisseur est avantageusement inférieure à 5 nm et de préférence inférieure à 3 nm.

A, B et C (Figure 2a et 2b) désignent trois bornes de connexion électrique. Dans la phase d'écriture, un courant est injecté entre les bornes A et B (de façon équivalente, une tension est appliquée entre ces bornes de façon à faire circuler un courant). Le courant passe dans la couche magnétique 53 et produit dans cette couche un champ magnétique efficace dû au champ Rashba et à l'interaction d'échange s-d, agissant sur l'aimantation locale (voir l'article précité de Ioan Mihai MIRON et collaborateurs). Ce champ efficace H_{eff} est dénommé de façon équivalente champ magnétique de spin-orbite ou champ effectif H_{eff}. Ce champ de spin-orbite, créé par le courant d'écriture appliqué, permet selon l'invention, la manipulation de l'aimantation. Dans le cas où la couche 52 est constituée par un matériau diélectrique, le courant d'écriture injecté latéralement ne passe pas à travers cette couche et ne l'endommage pas. Une fois le courant d'écriture interrompu, la direction d'aimantation est conservée.

La lecture de l'information stockée, typiquement l'orientation de l'aimantation dans la couche centrale 53, se fait aussi bien pour une structure de type jonction tunnel que de type vanne de spin, en injectant un courant de lecture de faible intensité (par exemple de l'ordre de quelques µA ou de quelques dizaines de µA pour le cas d'une jonction tunnel) entre les bornes C et B (ou de façon équivalente entre les bornes C et A, et en mesurant la tension entre ces bornes, ou bien en appliquant une tension constante entre les bornes B et C (ou de façon équivalente entre les bornes A et C), et en mesurant le courant qui circule entre ces bornes de façon à mesurer dans tous cas la résistance entre ces bornes. Celle-ci présente deux valeurs différentes selon que l'aimantation de la couche 53 est parallèle ou anti-parallèle à l'aimantation de la couche de référence 58. Le courant de lecture a une faible valeur de sorte que la barrière tunnel (dans le cas où la couche 52 est diélectrique) ne saurait être endommagée.

Des exemples d'architecture de mémoire seront maintenant présentés en relation avec les figures 3a et 3b.

On retrouve la couche magnétique 100 ayant une direction d'aimantation 107 contenue dans le plan de la couche 100 (qui correspond aux couches 13 et 53 des figures 1c à 1g, 2a et 2b) prise en sandwich entre deux couches non-magnétiques 101 et 102 (qui correspondent aux couches 12 et 14 des figures 1a à 1f et 52 et 54 des figures 2a et 2b). Les plots peuvent présenter une région en surépaisseur 102' (qui correspond aux régions 14' et 54' des figures 1c à 1g, 2a et 2b). Cette région 102' est conductrice et fait partie de la piste électriquement conductrice 102, lorsqu'elle est dans le même matériau que celle-ci ou bien constitue une deuxième couche non magnétique lorsqu'elle est dans un matériau différent.

Ici, pour simplifier, la couche 101 comprend à la fois cette couche 12 ou 52, mais aussi des couches magnétiques et non magnétiques permettant de définir un empilement de type jonction tunnel (ou vanne de spin) et ainsi de pouvoir lire l'état d'aimantation de la couche 100 (à la façon des couches 52, 58 et 59 des figures 2a et 2b).

Le retournement de l'aimantation de la couche 100 se fait au moyen d'un courant parcourant l'électrode inférieure 102 et la couche centrale magnétique 100.

Pour ce faire, la seconde couche non magnétique 102 constituant le sandwich est ici structurée sous la forme d'une piste d'amenée de courant. Cette piste peut aussi être constituée par exemple d'une autre couche d'un autre matériau située sous la couche 102.

L'injection du courant est contrôlée par un ou deux transistors (pour chaque plot).

Deux cas peuvent être pris pour exemple : soit on utilise deux transistors 103a et 103b fonctionnant en commutation, reliés par des pistes non représentées soit au potentiel de masse, soit à une tension choisie pour faire circuler le courant désiré (figure 3a), soit un seul transistor 103a, l'autre extrémité 105 (point B) de la piste 102 étant connectée à une piste portée à un potentiel constant (Figure 3b).

Pour un point mémoire donné, l'injection de courant pour l'écriture peut se faire selon deux variantes.

On utilise dans une première variante deux transistors 103a et 103b fonctionnant en commutation, dont la borne libre est portée alternativement à la masse pour l'un et à une tension V_{dd} pour l'autre, la tension V_{dd} étant choisie pour faire circuler un courant de valeur choisie, dans un sens ou dans l'autre suivant que le transistor 103a ou le transistor 103b est porté à la tension V_{dd}.

On utilise dans une deuxième variante un seul transistor 103a, l'autre extrémité de la piste 102 étant portée en 105 à une tension fixe. Dans ce cas, deux modes de fonctionnement sont alors possibles :
- Fonctionnement symétrique :
   La piste connectée au transistor 103a est portée au potentiel V_{dd} (ou à la masse) tandis que l'autre piste connectée en bout de la piste 102 en 105 est connectée à la masse (ou à V_{dd}). Cette configuration permet de générer plus de courant que celle qui suit.
- Fonctionnement asymétrique :
   La piste conductrice connectée à l'extrémité de la piste 102 en 105 est portée à un potentiel intermédiaire, par exemple V_{dd} /2, tandis que celle reliée au transistor 103a est portée respectivement au potentiel V_{dd} ou à la masse suivant le sens souhaité pour le courant. Cette configuration permet de générer moins de courant. Dans la configuration de l'invention, le courant d'écriture peut être envoyé sur une surface bien plus petite que celles utilisées dans les techniques conventionnelles, et ce courant est suffisant pour faire fonctionner le dispositif. Dans cet exemple de réalisation, on fait une économie de consommation sur le fonctionnement.

Dans les deux variantes, et pour la deuxième variante, que le fonctionnement soit symétrique ou asymétrique, l'inversion du sens de courant d'écriture permet d'écrire les points mémoire.

La figure 4 est un exemple de schéma électrique d'intégration d'un élément de mémoire pour former un réseau de cellules mémoires à deux dimensions par exemple avec une jonction tunnel.

Dans une direction, sont présentes des lignes de bit (bit line) ou lignes de digits 111₁, 111₂, 111₃, etc... connectées au drain des transistors 113₁, 113₂, 113₃, 113'₁, 113'₂, 113'₃, 113"₁, 113"₂, etc... et des lignes de bit conjuguées 112₁, 112₂, 112₃,... qui forment un réseau à deux dimensions.

Dans la direction perpendiculaire, on a des pistes de commande 110, 110', 110", ... des portes des transistors 113₁, 113₂, 113₃, 113'₁, 113'₂, 113'₃, 113"₁, 113"₂, etc... qui forment des lignes de mot (word lines).

Les repères 114₁, 114₂, 114₃, 114'₁, 114'₂, 114'₃, etc... désignent schématiquement un empilement selon l'invention comportant une jonction tunnel (ou une vanne de spin). La jonction tunnel ou la vanne de spin n'est pas traversée par un courant perpendiculairement au plan de ses couches lors d'une phase d'écriture, et elle n'est parcourue par un courant perpendiculairement au plan de ses couches que lors d'une phase de lecture.

Les points caractéristiques A, B et C ont été indiqués. Ils correspondent à ceux qui sont indiqués aux figures 2a, 2b, 3c, 3d, 5a, 5b, 6c et 6d (montage avec un seul transistor).

Les points A sont connectés aux sources des transistors 113₁, 113₂, 113₃, 113'₁, 113'₂, etc....

Les points B sont connectés à une ligne de bit conjuguée 112₁, 112₂, 112₃, etc... et les points C à une ligne de polarisation 115, 115', etc.... Les drains D des transistors 113₁, 113₂, 113₃, 113'₁, 113'₂, etc... sont connectés aux lignes de bit 111₁, 111₂, 111₃, etc...

Le bas des empilements 114₁, 114₂, etc... est donc la couche dont on change l'aimantation au moyen du courant d'écriture.

Dans tous les cas, on peut inverser les sources et les drains des transistors, les sources pouvant alors être connectées aux lignes de bit 111₁, 111₂, etc...et les drains aux points A.

Dans la phase d'écriture, d'un point mémoire, par exemple 114₁, la ligne de bit (ou "bit line") 111₁ et la ligne de bit conjuguée 112₁ qui sont associées à ce point mémoire sont portées selon le sens d'aimantation que l'on désire au potentiel Vdd (ou à la masse) et à la masse (ou au potentiel Vdd) dans le cas du fonctionnement symétrique décrit ci-dessus. Les autres lignes de bit 111₂, etc... et lignes de bit conjuguées 112₂, etc... associées aux autres points mémoire sont inactives. La ligne de mot 110 associée est portée au potentiel de commande nécessaire à la fermeture du transistor 113₁ (équivalent au transistor 73a ou 83a des figures précitées), pour permettre la circulation du courant d'écriture à travers le transistor 113₁.

Le courant d'écriture passe donc entre les points A et B dans un sens ou dans l'autre suivant le sens de l'aimantation que l'on désire. De façon à n'écrire que cette cellule, les autres lignes de mot 110', 110", etc... sont portées au potentiel qui ouvre les transistors. Aucun courant ne traverse perpendiculairement au plan des couches l'empilement de type jonction tunnel ou vanne de spin au risque de l'endommager. A cet effet, les lignes de polarisation 115, 115', etc... connectées aux points C des empilements sont inactives (ou ouvertes) dans cette phase d'écriture.

Dans la phase de lecture, par exemple du point mémoire 114₁, la "ligne de bit conjuguée" 112₁ associée à ce point mémoire est ouverte, ainsi que toutes les autres lignes de bit conjuguée" 112₂, etc... de façon à empêcher tout courant d'y circuler. La ligne de polarisation 115 associée au point mémoire envisagé est portée à un potentiel permettant le passage du courant de lecture (faible) dans la jonction tunnel ou dans la vanne de spin, tandis que toutes les autres lignes de polarisation 115', etc... sont déconnectées. La «ligne de mot» 110 associée est portée au potentiel permettant la fermeture du transistor 113₁ et un courant peut donc passer à travers la jonction tunnel ou la vanne de spin entre les points C et A. Pour ne lire que cette jonction tunnel ou cette vanne de spin, les autres lignes de mot « word line » 110', etc... sont portées au potentiel qui ouvre les transistors. Dans le cas d'une jonction tunnel, la lecture peut alors se faire par exemple suivant l'état de l'art par comparaison au moyen d'un amplificateur du courant passant dans la jonction à un courant de référence. Ce courant de lecture de faible densité de courant, passant perpendiculairement aux plans de l'empilement ne permet pas d'écrire la jonction dans cette phase de lecture. La procédure est la même dans le cas d'une vanne de spin.

## Revendications

1. Elément magnétique inscriptible comportant un empilement de couches présentant une couche magnétique d'écriture, l'empilement comporte une couche centrale (13, 53, 100) en au moins un matériau magnétique présentant une aimantation ayant une direction d'aimantation parallèle au plan de la couche centrale (13, 53, 100), celle-ci étant prise en sandwich entre une première (12, 52, 101) et une deuxième (14, 54, 102) couches externes en matériaux non magnétiques, la première couche externe (12, 52, 101) comportant un premier matériau non magnétique et la deuxième couche externe (14, 54, 102) comportant un deuxième matériau non magnétique différent du premier matériau non magnétique, au moins le deuxième matériau non magnétique étant électriquement conducteur, en ce qu'il comporte un dispositif pour faire passer un courant d'écriture à travers la deuxième couche externe (14, 54, 102) et la couche centrale (13, 53, 100) dans une direction de courant parallèle au plan de la couche centrale (13, 53, 100) et faisant un angle a de 90°±60°, notamment de 90°±30° et plus particulièrement 90°±15° avec ladite direction d'aimantation, pour générer dans la couche centrale (13, 53, 100) un champ magnétique effectif, ce courant étant appliqué soit dans un premier sens, soit dans un deuxième sens opposé au premier sens, pour orienter la direction d'aimantation dans un premier sens d'aimantation ou dans un deuxième sens d'aimantation opposé au premier sens d'aimantation, **caractérisé en ce que** la direction d'aimantation est orientée en réponse au champ de spin orbite généré par le courant d'écriture.

2. Elément magnétique selon la revendication 1, **caractérisé en ce que** la direction du courant d'écriture est perpendiculaire à ladite direction d'aimantation.

3. Elément de mémoire selon une des revendications précédentes, **caractérisé en ce que** la couche centrale (13, 53, 100) a une épaisseur comprise entre 0, 1 nm et 5 nm et de préférence inférieure ou égale à 3 nm.

4. Elément magnétique selon une des revendications précédentes, **caractérisé en ce que** la couche centrale (13, 53, 100) comporte un métal ou un alliage de métaux présentant dans l'empilement une anisotropie magnétique planaire, notamment Co, Ni, Fe, CoxFey, NixFey, CoxNiy.

5. Elément magnétique selon une des revendications précédentes, **caractérisé en ce qu'**au moins une couche externe est électriquement conductrice et est en un métal non-magnétique, tel que Pt, W, Ir, Ru, Pd, Cu, Au, Ag, Bi ou en un alliage de ces métaux, ou bien en un matériau semi-conducteur fortement dopé.

6. Elément magnétique selon la revendication 5, **caractérisé en ce que** l'épaisseur d'une dite couche externe électriquement conductrice est comprise entre 0,5 nm et 100 nm, et plus particulièrement entre 1nm et 10 nm et de préférence inférieure ou égale à 5 nm.

7. Elément magnétique selon une des revendications 5 ou 6, **caractérisé en ce que** les deux couches externes sont électriquement conductrices et sont en deux dits matériaux ou alliages non magnétiques différents.

8. Elément magnétique selon une des revendications 1 à 6, **caractérisé en ce que** la première couche externe est électriquement non conductrice et est notamment en un oxyde diélectrique tel que SiOx, AlOx, MgOx, TiOx, TaOx, ZnO, HfOx ou un nitrure diélectrique tel que SiNx, BNx.

9. Elément magnétique selon une des revendications 1 à 6, **caractérisé en ce que** la première couche externe est en un semi-conducteur tel que Si, Ge, ou GaAS, intrinsèque ou faiblement dopé, avec une résistivité supérieure à 0,1 Q.cm et de préférence supérieure à 1 Q.cm.

10. Elément magnétique selon une des revendications 8 ou 9, **caractérisé en ce que** l'épaisseur d'une dite première couche externe électriquement non conductrice est comprise entre 0,5nm et 200 nm, et plus particulièrement entre 0,5 nm et 100 nm et préférentiellement inférieure à 3 nm.

11. Elément magnétique selon une des revendications précédentes, **caractérisé en ce que** le courant d'écriture présente une densité de courant comprise entre 10⁴ A/cm² et 10⁹ A/cm² et de préférence entre 10⁵ A/cm² et 10⁸ A/cm².

12. Elément magnétique selon une des revendications précédentes, **caractérisé en ce que** la première couche externe (52) est recouverte d'une couche de lecture (58) en matériau magnétique et d'une électrode de lecture (59).

13. Elément magnétique selon la revendication 12, **caractérisé en ce que** la première couche externe (52) est en métal non-magnétique et **en ce qu'**elle forme avec la couche centrale (53), la couche de lecture (58) et l'électrode (59) une vanne de spin, et **en ce que** l'épaisseur de la première couche externe (52) est comprise entre 0,5 nm et 10 nm et de préférence comprise entre 0,5 nm et 5 nm.

14. Elément magnétique selon la revendication 12, **caractérisé en ce que** la première couche externe (52) est électriquement non conductrice et **en ce qu'**elle forme avec la couche centrale (53), la couche de lecture (58) et l'électrode de lecture (59) une jonction tunnel magnétique, et **en ce que** l'épaisseur de la première couche externe (12, 52, 101) est comprise entre 0,5 nm et 5 nm et de préférence inférieure à 3 nm.

15. Elément magnétique selon une des revendications précédentes, **caractérisé en ce qu'**au moins la première couche externe (54, 102) et la couche centrale (53, 100) forment un plot.

16. Elément magnétique selon la revendication 15, **caractérisé en ce que** le deuxième couche externe (54, 102) comporte une région (54', 102') en surépaisseur qui fait partie du plot.

17. Dispositif magnétique inscriptible, **caractérisé en ce qu'**il comporte une pluralité de plots selon une des revendications 15 ou 16 et **en ce que** la deuxième couche externe comporte une piste (54, 102) qui leur est commune.

18. Dispositif magnétique inscriptible **caractérisé en ce que** la première couche externe (52, 101), la couche centrale (53, 100) et une région en surépaisseur (54', 102') constituant la deuxième couche externe forment un plot selon la revendication 16, et **en ce qu'**il comporte une pluralité desdits plots, ainsi qu'une piste (54, 102) électriquement conductrice bordant la deuxième couche externe (54', 102') desdits plots pour injecter ledit courant à travers la deuxième couche externe (54', 102') et la couche centrale (53, 100) de chacun desdits plots, la deuxième couche externe étant en un matériau électriquement conducteur différent de celui de la piste électriquement conductrice (54, 102).

## Patentansprüche

1. Beschreibbares Magnetelement, das einen Stapel von Schichten aufweist, der eine magnetische Schreibschicht hat, wobei der Stapel eine mittlere Schicht (13, 53, 100) aus zumindest einem Magnetmaterial aufweist, die eine Magnetisierung mit einer Magnetisierungsrichtung parallel zur Ebene der mittleren Schicht (13, 52, 100) hat, wobei diese schichtartig zwischen einer ersten, äußeren Schicht (12, 52, 101) und einer zweiten, äußeren Schicht (14, 54, 102) aus nicht-magnetischen Material angeordnet ist, wobei die erste, äußere Schicht (12, 52, 100) ein erstes, nicht-magnetisches Material und die zweite, äußere Schicht (14, 54, 102) ein zweites, nicht-magnetisches Material, das sich von dem ersten, nicht-magnetischen Material unterscheidet, hat, wobei das zweite, nicht magnetische Material elektrisch leitend ist, wobei dieses eine Vorrichtung aufweist, um einen Schreibstrom durch die zweite, äußere Schicht (14, 54, 102) und die mittlere Schicht (13, 53, 100) in einer Stromrichtung parallel zur Ebene der mittleren Schicht (13, 53, 100) und mit einem Winkel von 90°±60°, insbesondere 90°±30° und genauer 90°±15°, zu der Magnetisierungsrichtung zu leiten, damit in der mittleren Schicht (13, 53, 100) ein effektives Magnetfeld erzeugt wird, wobei dieser Strom entweder mit einem ersten Richtungssinn oder und einem zweiten Richtungssinn, der zum ersten Richtungssinn entgegengesetzt ist, aufgebracht wird, damit die Magnetisierungsrichtung in einen ersten Magnetisierungsrichtungssinn oder einen zweiten Magnetisierungsrichtungssinn, der zum ersten Magnetisierungsrichtungssinn entgegengesetzt ist, ausgerichtet wird, **dadurch gekennzeichnet, dass** die Magnetisierungsrichtung im Ansprechen auf das Umlaufspinfeld, das durch den Schreibstrom erzeugt wird, ausgerichtet wird.

2. Magnetelement nach Anspruch 1, **dadurch gekennzeichnet, dass** die Richtung des Schreibstroms zur Magnetisierungsrichtung senkrecht ist.

3. Speicherelement nach einem der vorhergehenden Ansprüche, **dadurch gekennzeichnet, dass** die mittlere Schicht (13, 53, 100) eine Dicke zwischen 0,1 nm und 5 nm und vorzugsweise kleiner oder gleich 3 nm hat.

4. Magnetelement nach einem der vorhergehenden Ansprüche, **dadurch gekennzeichnet, dass** die mittlere Schicht (13, 53, 100) ein Metall oder eine Metalllegierung aufweist, die in dem Stapel eine planare, magnetische Anisotropie aufweist, insbesondere Co, Ni, Fe, CoxFey, NixFey, CoxNiy.

5. Magnetelement nach einem der vorhergehenden Ansprüche, **dadurch gekennzeichnet, dass** zumindest eine äußere Schicht elektrisch leitend ist und aus einem nicht magnetischen Material, wie Pt, W, Ir, Ru, Pd Cu, Au, Ag, Bi, oder aus einer Legierung dieser Metalle oder auch aus einem Halbleitermaterial, das stark dotiert ist, ist.

6. Magnetelement nach Anspruch 5, **dadurch gekennzeichnet, dass** die Dicke einer äußeren, elektrisch leitenden Schicht zwischen 0,5 nm und 100 nm und insbesondere zwischen 1 nm und 10nm, vorzugsweise kleiner oder gleich 5 nm, ist.

7. Magnetelement nach einem der Ansprüche 5 oder 6, **dadurch gekennzeichnet, dass** die zwei äußeren Schichten elektrisch leitend sind und aus zwei genannten Materialien oder Legierungen, die nicht magnetisch und verschieden sind, sind.

8. Magnetelement nach einem der Ansprüche 1 bis 6, **dadurch gekennzeichnet, dass** die erste, äußere Schicht elektrisch nicht leitend ist und insbesondere aus einem dielektrischen Oxid, wie SiOx, AlOx, MgOx, TiOx, TaOx, ZnO, HfOx, oder einem dielektrischen Nitrid, wie SiNx, BNx, ist.

9. Magnetelement nach einem der Ansprüche 1 bis 6, **dadurch gekennzeichnet, dass** die erste, äußere Schicht aus einem Halbleiter, wie Si, Ge oder GaAS, eigenleitend oder schwach dotiert, mit einem spezifischen Widerstand von höher als 0,1 Q cm und vorzugsweise höher als 1 Q cm ist.

10. Magnetelement nach einem der Ansprüche 8 oder 9, **dadurch gekennzeichnet, dass** die Dicke von einer genannten elektrisch nicht leitenden, ersten, äußeren Schicht zwischen 0,5 nm und 200 nm und insbesondere zwichen 0,5 nm und 100 nm und vorzugsweise kleiner als 3 nm ist.

11. Magnetelement nach einem der vorhergehenden Ansprüche, **dadurch gekennzeichnet, dass** der Schreibstrom eine Stromdichte zwischen 10⁴ und 10⁹ A/cm² und vorzugsweise zwischen 10⁵ und 10⁸ A/cm² hat.

12. Magnetelement nach einem der vorhergehenden Ansprüche, **dadurch gekennzeichnet, dass** die erste, äußere Schicht (52) mit einer Leseschicht (58) aus einem Magnetmaterial und einer Leseelektrode (59) bedeckt ist.

13. Magnetelement nach Anspruch 12, **dadurch gekennzeichnet, dass** die erste, äußere Schicht (52) aus einem nicht magnetischen Metall ist und dass diese mit der mittleren Schicht (53), der Leseschicht (58) und der Elektrode (59) ein Spinventil bildet und dass die Dicke der ersten, äußeren Schicht (52) zwischen 0,5 nm und 10 nm und vorzugsweise zwischen 0,5 nm und 5 nm ist.

14. Magnetelement nach Anspruch 12, **dadurch gekennzeichnet, dass** die erste, äußere Schicht (52) elektrisch nicht leitend ist und dass diese mit der mittleren Schicht (53), der Leseschicht (58) und der Leseelektrode (59) eine magnetische Tunnelverbindung bildet und dass die Dicke der ersten, äußeren Schicht (12, 52, 101) zwischen 0,5 nm und 5 nm und vorzugsweise kleiner als 3 nm ist.

15. Magnetelement nach einem der vorhergehenden Ansprüche, **dadurch gekennzeichnet, dass** zumindest die erste äußere Schicht (54, 102) und die mittlere Schicht (53, 100) einen Kontakt bilden.

16. Magnetelement nach Anspruch 15, **dadurch gekennzeichnet, dass** die zweite, äußere Schicht (54, 102) einen Bereich (54', 102') mit Überdicke, der Teil des Kontaktes ist, aufweist.

17. Beschreibbare Magnetvorrichtung, **dadurch gekennzeichnet, dass** diese eine Vielzahl an Kontakten nach einem der Ansprüche 15 oder 16 aufweist und die zweite äußere Schicht eine Bahn (54, 102), die diesen gemeinsam ist, aufweist.

18. Beschreibbare Magnetvorrichtung, **dadurch gekennzeichnet, dass** die erste, äußere Schicht (52, 101), die mittlere Schicht (53, 100) und ein Bereich (54', 102') mit Überdicke, der die zweite, äußere Schicht bildet, einen Kontakt nach Anspruch 16 bildet und dass diese eine Vielzahl der Kontakte aufweist, sowie eine elektrisch leitende Bahn (54, 102), die die zweite, äußere Schicht (54', 102') der Kontakte einfasst, um den Strom durch die zweite, äußere Schicht (54', 102') und die mittlere Schicht (53, 100) von jedem der Kontakte hindurch zu injizieren, wobei die zweite, äußere Schicht aus einem elektrisch leitenden Material ist, das sich von dem der elektrisch leitenden Bahn (54, 102) unterscheidet.

## Claims

1. A writable magnetic element comprising a stack of layers presenting a write magnetic layer, the stack has a central layer (13, 53, 100) of at least one magnetic material presenting magnetization having a magnetization direction that is parallel to the plane of the central layer (13, 53, 100), which layer is sandwiched between first and second outer layers (12, 52, 101; 14, 54, 102) of non-magnetic materials, the first outer layer (12, 52, 101) comprising a first non-magnetic material and the second outer layer (14, 54, 102) comprising a second non-magnetic material that is different from the first non-magnetic material, at least the second non-magnetic material being electrically conductive, and in that it includes a device to cause a write current to pass through the second outer layer (14, 54, 102) and the central layer (13, 53, 100) in a current flow direction parallel to the plane of the central layer (13, 53, 100) at an angle α lying in the range 90° ± 60°, in particular 90° ± 30°, and more particularly 90° ± 15° relative to said magnetization direction in order to generate an effective magnetic field in the central layer (13, 53, 100), the current being applied either in a first direction or in a second direction opposite to the first, in order to orient the magnetization direction in a first magnetization direction or in a second magnetization direction opposite to the first, **characterized in that** the magnetization direction is oriented in response to the spin-orbit field generated by the writing current.

2. A magnetic element according to claim 1, **characterized in that** the write current direction is perpendicular to said magnetization direction.

3. A magnetic element according to either preceding claim, **characterized in that** the central layer (13, 53, 100) has thickness lying in the range 0.1 nm to 5 nm, and preferably less than or equal to 3 nm.

4. A magnetic element according to any preceding claim, **characterized in that** the central layer (13, 53, 100) comprises a metal or metal alloy presenting planar magnetic anisotropy in the stack, in particular Co, Ni, Fe, CoₓFe_{y}, NiₓFe_{y}, CoₓNi_{y}.

5. A magnetic element according to any preceding claim, **characterized in that** at least one outer layer is electrically conductive and is made of a non-magnetic metal such as Pt, W, Ir, Ru, Pd, Cu, Au, Ag, Bi, or of an alloy of said metals, or indeed is made of a highly doped semiconductor material.

6. A magnetic element according to claim 5, **characterized in that** the thickness of a said electrically conductive outer layer lies in the range 0.5 nm to 100 nm, and more particularly in the range 1 nm to 10 nm, and is preferably less than or equal to 5 nm.

7. A magnetic element according to claim 5 or claim 6, **characterized in that** both outer layers are electrically conductive, and are made of two different ones of said non-magnetic alloys or materials.

8. A magnetic element according to any one of claims 1 to 6, **characterized in that** the first outer layer is electrically non-conductive, and in particular is made of a dielectric oxide such as SiOₓ, AlOₓ, MgOₓ, TiOₓ, TaOₓ, ZnO, HfOₓ, or a dielectric nitride such as SiNₓ, Bnₓ.

9. A magnetic element according to any one of claims 1 to 6, **characterized in that** the first outer layer is a semiconductor such as Si, Ge, or GaAs, that is intrinsic or lightly doped, presenting resistivity greater than 0.1 Ω.cm and preferably greater than 1 Ω.cm.

10. A magnetic element according to claim 8 or claim 9, **characterized in that** the thickness of a said dielectrically non-conductive first outer layer lies in the range 0.5 nm to 200 nm, and more particularly in the range 0.5 nm to 100 nm, and is preferably less than 3 nm.

11. A magnetic element according to any preceding claim, **characterized in that** the write current presents current density lying in the range 10⁴ A/cm² to 10⁹ A/cm², and preferably in the range 10⁵ A/cm² to 10⁸ A/cm².

12. A magnetic element according to any preceding claim, **characterized in that** the first outer layer (52) is covered by a read layer (58) made of magnetic material, and by a read electrode (59).

13. A magnetic element according to claim 12, **characterized in that** the first outer layer (52) is made of non-magnetic metal, **in that** it co-operates with the central layer (53), the read layer (58), and the electrode (59) to form a spin valve, and **in that** the thickness of the first outer layer (52) lies in the range 0.5 nm to 10 nm and preferably lies in the range 0.5 nm to 5 nm.

14. A magnetic element according to claim 12, **characterized in that** the first outer layer (52) is electrically non-conductive, **in that** it co-operates with the central layer (53), the read layer (58), and the read electrode (59) to form a magnetic tunnel junction, and **in that** the thickness of the first outer layer (12, 52, 101) lies in the range 0.5 nm to 5 nm, and is preferably less than 3 nm.

15. A magnetic element according to any preceding claim, **characterized in that** at least the first outer layer (54, 102) and the central layer (53, 100) form a block.

16. A magnetic element according to claim 15, **characterized in that** the second outer layer (54, 102) includes a region (54', 102') of extra thickness that forms a portion of the block.

17. A writable magnetic device, **characterized in that** it comprises a plurality of blocks according to claim 15 or claim 16, and **in that** the second outer layer includes a track (54, 102) that is common to the blocks.

18. A writable magnetic device, **characterized in that** the first outer layer (52, 101), the central layer (53, 100), and a region of extra thickness (54', 102') constituting the second outer layer form a block according to claim 16, and **in that** it includes a plurality of said blocks together with an electrically conductive track (54, 102) bordering the second outer layers (54', 102') of said blocks in order to inject said current through said second outer layers (54', 102') and the central layers (53, 100) of each of said blocks, the second outer layers being made of an electrically conductive material that is different from the material of the electrically conductive track (54, 102).
